(19) Europäisches Patentamt
European Patent Office
Office européen des brevets

(11) Publication number : **0 382 932 B1**

(12) # EUROPEAN PATENT SPECIFICATION

(45) Date of publication of patent specification : **09.11.94 Bulletin 94/45**

(51) Int. Cl.$^5$ : **G03F 7/075**

(21) Application number : **89123324.9**

(22) Date of filing : **16.12.89**

(54) **Process for the vapor deposition of polysilanes.**

(30) Priority : **15.02.89 US 311326**

(43) Date of publication of application : **22.08.90 Bulletin 90/34**

(45) Publication of the grant of the patent : **09.11.94 Bulletin 94/45**

(84) Designated Contracting States : **CH DE ES FR GB IT LI NL SE**

(56) References cited :
**EP-A- 0 136 421**
**US-A- 4 348 473**
**US-A- 4 781 942**

(73) Proprietor : **International Business Machines Corporation**
**Old Orchard Road**
**Armonk, N.Y. 10504 (US)**

(72) Inventor : **Dobuzinsky, David M.**
**26 Cascade Street**
**Essex Junction Vermont (US)**
Inventor : **Hakey, Mark C.**
**12 Jackson Road**
**Milton Vermont (US)**
Inventor : **Holmes, Steven J.**
**117 Morse Place**
**Burlington Vermont (US)**
Inventor : **Horak, David V.**
**47 Briar Lane**
**Essex Junction Vermont (US)**

(74) Representative : **Schäfer, Wolfgang, Dipl.-Ing.**
**IBM Deutschland Informationssysteme GmbH**
**Patentwesen und Urheberrecht**
**D-70548 Stuttgart (DE)**

EP 0 382 932 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a process for forming a film by vapor deposition on a substrate. The invention also pertains to the use of such a film in a lithographic process.

In the field of semiconductor processing, it is generally known to use polysilane materials as positive photoresists. See, for example, U.S. Pat. No. 4,587,205, issued to Harrah, et al. on May 6, 1986, and U.S. Pat. No. 4,588,801, issued to Harrah, et al. on May 13, 1986. See also, West, R., "Polysilane High Polymers and Their Technological Applications," Actual. Chim., (3), 64-70 (1986).

The art discloses a number of methods for the preparation of such polysilane compositions. For example, in U.S. Pat. No. 4,578,495, issued to Soula, et al. on Mar. 25, 1986, polysilanes are prepared by contacting, in an inert atmosphere, at least one disilane with a catalyst system which includes an ionic inorganic salt, $M^+A^-$, and a compound that complexes the $M^+$ cation of the salt. Reference is also made to U.S. Pat. No. 4,667,046, issued to Frey, et al. on May 19, 1987, which provides another method for making polysilanes. In that patent, the method involves reacting at least one methoxy-containing disilane with an SiH-containing silane in the presence of at least one alcoholate, MOR, where M is an alkali metal and R is a select monovalent hydrocarbon radical. Further, in U.S. Pat. No. 4,298,558, issued to Baney, et al. on Nov. 3, 1981, polysilane compositions are prepared by reacting, under anhydrous conditions, a select polysilane with a reagent selected from carbinols, alcoholates and alkyl orthoformates.

Yet another approach for preparing polysilanes is disclosed in U.S. Pat. No. 3,399,223, issued to Atwell, et al. on Aug. 27, 1968. That process involves heating under neutral conditions, at a temperature of 165-350°C, a select polysilane to effect a redistribution between Si-Si bonds and Si-OR bonds.

In the use of polysilanes as photoresists, the procedure generally involves first preparing the desired polysilane, e.g. by one of the methods described above, and then dissolving it in a suitable solvent. After filtering the solution to remove impurities, the solution is spin applied to a substrate. This approach cannot be followed with many polysilanes, however, because they do not readily dissolve in commonly used solvents. Another drawback is that spin application does not result in a uniform coating of the material over horizontal and vertical surfaces on the substrate.

Efforts have been made to overcome the latter problem, so as to obtain a more uniform coating of photoresist, one technique involving the application of two or more layers. But this method further involves the use of two or more development steps, with a resulting increase in the complexity and cost of the overall process.

Another approach which attempts to obtain a more even coating thickness is disclosed in U.S. Pat. No. 4,675,273, issued to Woods, et al. on Jun. 23, 1987, where a photoresist is formed on a substrate by vapor deposition. However, in practice, the process first requires treating the substrate surface with a suitable activator. Also, the process involves the use of cyanoacrylate monomers; there is no disclosure that any other types of monomers could be satisfactorily employed. Reference is also made to U.S. Pat. No. 4,781,942, issued to Leyden, et al. on Nov. 1, 1988, where a protective layer of a siloxane polymer is deposited on the surface of a substrate. According to this process, a select monomer precursor is reacted with a select oxygen-containing precursor in the presence of radiation, resulting in formation of a siloxane polymer on a substrate.

EP-A-136 421 discloses a microlithographic process wherein a pattern-exposed polymer film is deposited on the surface of a substrate by placing said substrate inside a closed chamber containing tetra-vinyl silane and exposing the monomer vapour to a patterned beam of ions.

Thus, there is a need in the art for a process for depositing a film of a polysilane material, which overcomes the disadvantages of spin application, which forms a more uniform coating over horizontal and vertical surfaces on a substrate, and which can be utilized for depositing a variety of polysilanes, not all of which are utilizable by way of spin application.

Now, in accordance with the invention, a new process has been discovered for forming a film comprising a polysilane composition on a substrate. In accordance with the invention, a substrate is exposed to the vapor of a polymerizable silane monomer under such conditions as to deposit on the substrate a film comprising a polysilane composition. In another aspect of the invention, the film is then exposed in a predetermined pattern to radiation, and the radiation exposed portions of the film are removed. This process is particularly useful in the production of semiconductor devices on silicon wafers.

It is a feature of the invention that a film useful as a positive-working photoresist is formed directly on a substrate, thus avoiding the cumbersome steps of first preparing the polymer, dissolving it in a solvent and purifying it. As an additional feature, it has been found that a film comprising a polysilane composition can be formed on the substrate, which is of relatively uniform thickness, over horizontal and vertical surfaces, as compared with that obtainable through the use of conventional spin application techniques. Still further, a wide variety of polysilane compositions can be deposited, which are not otherwise utilizable by spin application,

since they are not readily dissolvable in solvents ordinarily used.

In accordance with the process of the invention, a substrate is exposed to the vapor of a polymerizable silane monomer. Preferred silane monomers include those having the formula

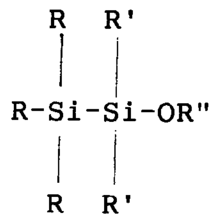

wherein R is H; $C_1$-$C_4$ alkyl, alkenyl, alkynyl, alkoxy or alkyl silyl; aryl; or amino; wherein R′ is H; $C_1$-$C_4$ alkyl, alkenyl, alkynyl, alkoxy or alkyl silyl; aryl; amino; halo; or halomethyl; and wherein R″ is H; $C_1$-$C_4$ alkyl, alkenyl, alkynyl, alkoxy or alkyl silyl; aryl; or amino.

A more preferred group of silane monomers for use according to the invention include those having the above formula wherein R is $C_1$-$C_3$ alkyl; R′ is $C_1$-$C_4$ alkyl, trimethyl silyl, aryl, fluoro or fluoromethyl; and R″ is $C_1$ -$C_3$ alkyl. In a particularly preferred embodiment of the invention, pentamethylmethoxydisilane is employed.

Typically, the substrate which is utilized is silicon dioxide coated silicon or silicon, although the process can be applied to other substrates if so desired.

In carrying out the process of the invention, the silane monomer is heated to a suitable temperature so as to produce sufficient concentration of vapor for polysilane deposition on the substrate. The general reaction for polysilane formation may be illustrated as follows:

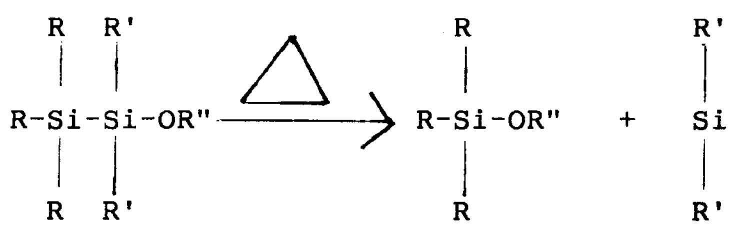

The diradical polymerizes to yield $[Si(R')_2]_n$, where n is an integer ranging from about 2-1,000, depending generally upon the nature of the starting material, the reaction conditions and so forth.

The actual reaction conditions, i.e. temperature, pressure and time, may vary over wide ranges and are generally dependent on the silane monomer and the exact equipment being employed, as well as other factors familiar to those skilled in the art. In general, however, temperatures ranging from about 200 to about 650°C and pressures ranging from about 0.067 mbar to about 133.3 mbar (50 mtorr to about 100 torr) for a period of about 1 to about 20 minutes are typical. Reaction temperatures from about 500 to about 600°C and pressures from about 2.67 to about 6.67 mbar (2 to about 5 torr) are preferred.

The reaction may be carried out in the presence or absence of a solvent. In the latter case, the silane monomer (or mixture of monomers) serves as a solvent. When a solvent is employed, it must be selected so as to solubilize the silane monomer, be chemically inert with respect to the silane monomer, and so forth.

Various other materials may be added to the silane monomer prior to polymerization to change the properties of the resulting film. For example, cross-linkers, chain terminators to control molecular weight, other co-monomers to vary optical properties, etc. may be employed, as will be apparent to those skilled in the art.

The film formed in accordance with the invention will generally have a thickness from about 0.1 to about 1 µm, depending upon the nature of the monomer used, the reaction conditions, etc.

To form an image on the substrate, the film is then exposed in a predetermined pattern to radiation, such as UV or ionizing radiation sources, including X-ray, gamma ray and charged particle beams, e.g., electron beams. Either direct write or photomask techniques may be suitably used. Preferably, the film is exposed through a mask to deep UV radiation, most preferably with a wavelength in the range of about 240-260 nm. Following the exposure step, the portions of the film which were exposed to the radiation are removed. A conventional developer, such as isopropyl alcohol, can be used for this purpose. The removal of the exposed portions of the film results in a polymer film with the predetermined pattern on the substrate.

Thus, in accordance with the process of the present invention, there is provided a film of a polysilane composition, formed directly on a substrate in the vapor phase. The film is adherent and coats relatively uniformly over horizontal and vertical surfaces on the substrate; and it is effectively employed as a positive-working photoresist to form a desired image on the substrate.

The following example is provided to illustrate the invention.

EXAMPLE

A sample (1.5 ml) of pentamethylmethoxydisilane, obtained from Petrarch, Inc. (98% purity), was placed in a 20 ml glass ampule attached to a vacuum manifold. The manifold was composed of 3 parts: the reagent vessel, a quartz furnace tube, and a deposition chamber. The furnace tube was 25 cm in length and 2 cm in diameter. The deposition chamber was approximately 40 cm long and 15 cm in diameter. A silicon wafer was placed in the deposition chamber opposite the furnace tube. The furnace was heated to 600°C and the reagent ampule was heated to 95°C. After evacuation of the apparatus, the valve to the vacuum pump was closed, and the reagent was introduced. The system pressure rose to several torr for a period of 1-2 min., and then dropped to less than 1.33 mbar (1 torr) as the reaction progressed. Upon removal of the wafer from the deposition chamber, a circular film approximately 40 mm in diameter was observed. The film was thicker at the center, with the following measurements being taken:

| Radial Position (mm) | Film Thickness (nm) |
|---|---|
| 0 | 431.1 |
| 3 | 413.7 |
| 6 | 350.1 |
| 15 | 176.1 |
| 20 | 108.1 |

UV spectroscopic characterization showed absorbance by the film at 200-270 nm, with very little absorbance above 300 nm. For this purpose, a sample was prepared by deposition on a quartz wafer.

Film samples were exposed on a proximity printer at 240-260 nm. A variable transmission mask was used to generate exposures of 0-240 mj/cm$^2$ on each wafer. The mask contained a series of equal line/space patterns between 1.0 and 2.0 µm. Expose values of 70-80 mj/cm$^2$ were optimum. Positive tone images were developed with a 30 sec. rinse with isopropyl alcohol.

**Claims**

1. Process for forming a film on a substrate, comprising exposing said substrate to the vapor of a polymerizable silane monomer under such conditions as to deposit on said substrate a film comprising a polysilane composition having a chemical backbone characterized by silicon-silicon bonding.

2. Process of claim 1, wherein said polymerizable silane monomer has the formula

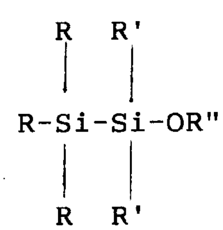

wherein:
R is H; $C_1$-$C_4$ alkyl, alkenyl, alkynyl, alkoxy or alkyl silyl; aryl; or amino;
R′ is H; $C_1$-$C_4$ alkyl, alkenyl, alkynyl, alkoxy or alkyl silyl; aryl; amino; halo; or halomethyl; and
R″ is H; $C_1$-$C_4$ alkyl, alkenyl, alkynyl, alkoxy or alkyl silyl; aryl; or amino.

3. Process of claim 2, wherein:
R is $C_1$-$C_3$ alkyl;
R′ is $C_1$-$C_4$ alkyl, trimethyl silyl, aryl, fluoro or fluoromethyl; and
R″ is $C_1$-$C_3$ alkyl.

4. Process of claim 3, wherein said polymerizable silane monomer is pentamethylmethoxydisilane.

5. Process of claim 1, wherein said substrate is silicon dioxide coated silicon or silicon.

6. Process of claim 1, wherein said polymerizable silane monomer is heated to a temperature ranging from about 200 to about 650°C at a pressure ranging from about 0.067 mbar to about 133.3 mbar (50 mtorr to about 100 torr) for a period of about 1 to about 20 minutes.

7. Process of claim 6, wherein said temperature ranges from about 500 to about 600°C and said pressure ranges from about 2.67 to about 6.67 mbar (2 to about 5 torr).

8. Process of one or several of claims 1 to 7 for forming an image on a substrate, said process further comprising the steps of:
after depositing on said substrate a film comprising a polysilane composition;
exposing said film in a predetermined pattern to radiation; and
removing the radiation exposed portions of said film.

9. Process of claim 8, wherein said film is exposed to radiation having a wavelength ranging from about 240 to about 260 nanometers.

10. Process of claim 8, wherein said polymerizable silane monomer is pentamethylmethoxydisilane, and said substrate is silicon dioxide coated silicon or silicon.

11. Process of claim 8 for forming an image on a substrate, said method comprising the steps of:
exposing said substrate to the vapor of a polymerizable silane monomer, which is heated to a temperature ranging from about 500 to about 600°C at a pressure ranging from about 2.67 to about 6.67 mbar (2 to about 5 torr), so as to deposit on said substrate a film comprising a polysilane composition, said polymerizable silane monomer having the formula

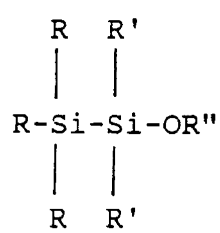

wherein:
R is H; $C_1$-$C_4$ alkyl, alkenyl, alkynyl, alkoxy or alkyl silyl; aryl; or amino;
R′ is H; $C_1$-$C_4$ alkyl, alkenyl, alkynyl, alkoxy or alkyl silyl; aryl; amino; halo; or methyl halo; and
R″ is H; $C_1$-$C_4$ alkyl, alkenyl, alkynyl, alkoxy or alkyl silyl; aryl; or amino;
exposing said film in a predetermined pattern to radiation; and
removing the radiation exposed portions of said film.

## Patentansprüche

1. Verfahren zur Bildung eines Films auf einem Substrat, indem das Substrat dem Dampf eines polymerisierbaren Silanmonomers so ausgesetzt wird, daß auf dem Substrat ein Film einer Polysilanverbindung abgeschieden wird, die ein chemisches Rückgrat aufweist, das durch eine Silizium-Silizium-Bindung charakterisiert ist

2. Das Verfahren von Anspruch 1, wobei das polimerisierbare Silanmonomer die folgende Formel hat:

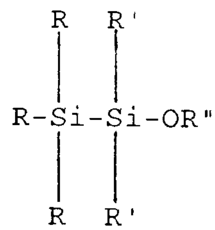

und wobei
R H, $C_1$-$C_4$ Alkyl, Alkenyl, Alkynyl, Alkoxy oder Alkylsilyl, Aryl oder Amino ist;
R′ H, $C_1$-$C_4$ Alkyl, Alkenyl, Alkynyl, Alkoxy oder Alkylsilyl, Aryl, Amino, Halo oder Halomethyl ist und
R″ H, $C_1$-$C_4$ Alkyl, Alkenyl, Alkynyl, Alkoxy oder Alkylsilyl, Aryl oder Amino ist.

3. Verfahren nach Anspruch 2, wobei folgendes gilt:
R ist $C_1$-$C_3$ Alkyl;
R′ ist $C_1$-$C_4$ Alkyl, Trimethylsilyl, Aryl, Fluor oder Fluoromethyl und
R″ ist $C_1$-$C_3$ Alkyl.

4. Verfahren nach Anspruch 3, wobei das polymerisierbare Silanmonomer Pentamethylmethoxydisilan ist.

5. Verfahren nach Anspruch 1, wobei das Substrat mit Siliziumdioxyd beschichtetes Silizium oder Silizium ist.

6. Verfahren nach Anspruch 1, wobei das polymerisierbare Silanmonomer über einen Zeitraum von ca. 1 bis ca. 20 Minuten auf eine Temperatur von ca. 200 bis ca. 650°C erhitzt wird bei einem Druck von ca. 0,067 bis ca. 133,3 mbar (50 mtorr bis ca. 100 torr).

7. Verfahren nach Anspruch 6 wobei die Temperatur von ca. 500 bis ca. 600°C und der Druck von ca. 2,67 bis ca. 6,67 mbar (2 bis ca. 5 torr) reicht.

8. Verfahren nach einem oder mehreren der Ansprüche 1 bis 7 zum Erstellen eines Bilds auf einem Substrat außerdem die folgenden Schritte umfassend:
nach dem Abscheiden eines Films auf dem Substrat, der eine Polysilanverbindung enthält;
Bestrahlen des Films nach einem vordefinierten Muster und Entfernen der belichteten Teile des Films.

9. Verfahren nach Anspruch 8, wobei der Film mit einer Wellenlänge von ca. 240 bis ca. 260 nm bestrahlt wird.

10. Verfahren nach Anspruch 8, wobei das polymerisierbare Silanmonomer Pentamethylmethoxydisilan und das Substrat mit Siliziumdioxyd beschichtetes Silizium oder Silizium ist.

11. Verfahren nach Anspruch 8 zum Erstellen eines Bilds auf einem Substrat die folgenden Schritte umfassend:
Substrat dem Dampf eines polymerisierbaren Silanmonomers aussetzen, das auf eine Temperatur von ca. 500 bis ca. 600°C erhitzt wird bei einem Druck von ca. 2,67 bis ca. 6,67 mbar (2 bis ca. 5 torr), so daß sich auf dem Substrat ein Film abscheidet, der eine Polysilanverbindung enthält, wobei das polymerisierbare Silanmonomer die folgende Formel hat:

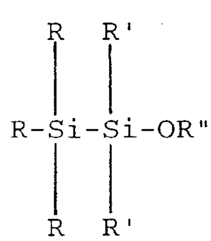

und wobei

R H, $C_1$-$C_4$ Alkyl, Alkenyl, Alkynyl, Alkoxy oder Alkylsilyl, Aryl oder Amino ist;
R′ H, $C_1$-$C_4$ Alkyl, Alkenyl, Alkynyl, Alkoxy oder Alkylsilyl, Aryl, Amino, Halo oder Halomethyl ist und
R″ H, $C_1$-$C_4$ Alkyl, Alkenyl, Alkynyl, Alkoxy oder Alkylsilyl, Aryl oder Amino ist;
Bestrahlen des Films nach einem vordefinierten Muster und
Entfernen der belichteten Teile des Films.

## Revendications

1. Procédé pour former une couche sur un substrat, consistant à exposer ledit substrat à la vapeur d'un monomère silanique polymérisable dans des conditions permettant de déposer sur ledit substrat une couche comprenant un composé polysilanique dont l'épine dorsale est caractérisée par une liaison chimique silicium-silicium.

2. Procédé selon la revendication 1, dans lequel ledit monomère silanique polymérisable a la formule

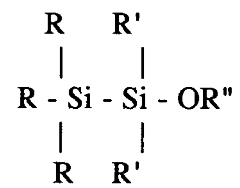

   où :
   R est H; $C_1$-$C_4$ alkyle, alkényle, alkynyle, alkoxy ou alkyle silyle; aryle; ou amino;
   R′ est H; $C_1$-$C_4$ alkyle, alkényle, alkynyle, alkoxy ou alkyle silyle; aryle; amino; halo; ou halométhyle; et
   R″ est H; $C_1$-$C_4$ alkyle, alkényle, alkynyle, alkoxy ou alkyle silyle; aryle; ou amino.

3. Procédé selon la revendication 2, dans lequel
   R est $C_1$-$C_3$ alkyle;
   R′ est $C_1$-$C_4$ alkyle, triméthyle silyle, aryle, fluoro ou fluorométhyle; et
   R″ est $C_1$-$C_3$ alkyle.

4. Procédé selon la revendication 3, dans lequel ledit monomère silanique polymérisable est du pentaméthylméthoxydisilane.

5. Procédé selon la revendication 1, dans lequel ledit substrat est du silicium recouvert de dioxyde de silicium ou du silicium.

6. Procédé selon la revendication 1, dans lequel ledit monomère silanique polymérisable est chauffé à une température comprise entre environ 200 et environ 650°C à une pression comprise entre environ 0,067 mbar et environ 133,3 mbar (50 mtorr et environ 100 torr) pour une durée comprise entre environ 1 et environ 20 minutes.

7. Procédé selon la revendication 6, dans lequel ladite température est comprise entre environ 500 et environ 650°C, et ladite pression est comprise entre environ 2,67 et environ 6,67 mbar (2 et environ 5 torr).

8. Procédé selon l'une quelconque des revendications 1 à 7 pour former une image sur un substrat, ledit procédé comprenant, de plus, les étapes consistant à :
   après avoir déposé sur ledit substrat une couche comprenant un composé polysilanique;
   exposer ladite couche à un rayonnement selon un motif prédéterminé; et
   ôter les portions exposées au rayonnement de ladite couche.

9. Procédé selon la revendication 8, dans lequel ladite couche est exposée à un rayonnement dont la longueur d'onde est comprise entre environ 240 et environ 260 nanomètres.

10. Procédé selon la revendication 8, dans lequel ledit monomère silanique polymérisable est du pentaméthylméthoxydisilane et ledit substrat est du silicium recouvert de dioxyde de silicium ou du silicium.

**11.** Procédé selon la revendication 8 pour former une image sur un substrat, ledit procédé comprenant les étapes consistant à :
exposer ledit substrat à la vapeur d'un monomère silanique polymérisable chauffé à une température comprise entre environ 500 et environ 600°C, à une pression comprise entre environ 2,67 et environ 6,67 mbar (2 et environ 5 torr), de façon à déposer sur ledit substrat une couche comprenant un composé polysilanique, ledit monomère silanique polymérisable ayant la formule

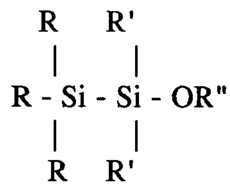

où :
R est H; $C_1$-$C_4$ alkyle, alkényle, alkynyle, alkoxy ou alkyle silyle; aryle; ou amino;
R′ est H; $C_1$-$C_4$ alkyle, alkényle, alkynyle, alkoxy ou alkyle silyle; aryle; amino; halo; ou halométhyle; et
R″ est H; $C_1$-$C_4$ alkyle, alkényle, alkynyle, alkoxy ou alkyle silyle; aryle; ou amino;
exposer ladite couche à un rayonnement selon un motif prédéterminé; et
ôter les portions exposées au rayonnement de ladite couche.